# EUROPEAN PATENT APPLICATION

(11) **EP 4 585 717 A2**
(43) Date of publication of application: **16.07.2025**
(21) Application number: 25180594.1
(22) Date of filing: 10.09.2019
(51) Int. Cl.: C23C 28/02

(54) **PLASMA JET DEPOSITION PROCESS**

(62) Divisional of application: 19769415.1
(71) Applicant: UCL Business Ltd, London WC1E 6BT (GB)
(72) Inventor: SENER, Mustafa Emre, London, WC1H 0AJ (GB); CARUANA, Daren Joseph, London, WC1H 0AJ (GB)
(74) Representative: Mewburn Ellis LLP

(57) **Abstract**

Processes and apparatus are described for atmospheric pressure plasma jet deposition onto a substrate. The process comprises feeding a solution comprising a dissolved metal precursor into a plasma jet. The dissolved metal precursor comprises a precursor metal selected from Groups 2 to 16, with the proviso that the precursor metal does not comprise Mn. The plasma jet is directed towards a surface of the substrate such that material from the plasma jet becomes deposited onto the surface of the substrate. The process provides a means to manufacture conductive, semiconducting or insulating deposits on a substrate in a material-efficient manner without the need for high-temperature post-treatment steps.

## Description

### Field of the Invention

The present invention relates to processes and apparatus for preparing a deposit on a substrate by plasma jet deposition, and particularly, although not exclusively, to processes and apparatus for preparing metallic tracks on a substrate by plasma jet deposition.

### Background

Current methods for production of deposits on substrates, such as the deposition of copper conductive traces, employ inkjet physical deposition, aerosol deposition or lithography, the latter being a subtractive process that requires multiple steps such as bonding, sintering, electroplating and etching. The wet chemistry routes required for the lithographic process produce a lot of waste and render it unsuitable for use with many substrates. On the other hand inkjet and aerosol deposition processes require the use of expensive nanoparticle or organometallic inks, and post-treatment processes at elevated temperature to sinter the material within the deposit.

Plasma jet printing is a relatively new, mostly unexplored technology that uses low-temperature atmospheric pressure plasma jets for spatially controlled deposition of thin films on surfaces. This technique relies on a jet of low-temperature plasma to transport a nanoparticle precursor to a substrate for deposition. Gandhiraman et al. (Plasma jet printing for flexible substrates, Appl. Phys. Lett. 2016, 108 (12), 4) have applied the technique for the deposition of silver nanowire conductive traces from a suspension of silver nanowires in methanol.

This and similar processes often require a precursor which contains hydrocarbons such as methanol, or other volatile organic compounds, which raises safety and environmental issues as well as causing contamination of the deposited material with carbon impurity from the solvent.

Plasma is a state of matter, defined as a partly or totally ionized gas, composed of neutral atoms and molecules alongside ions and electrons. Plasmas can be broadly classified into thermal and non-thermal (or "cold") plasmas. Thermal plasmas contain electrons and heavy particles (ions and neutrals) that exist in thermodynamic or close to thermodynamic equilibrium. On the other hand, non-thermal plasmas (NTPs) contain species with degrees of freedom that are not in equilibrium with each other. For example, the kinetic energy possessed by the electrons in a non-equilibrium plasma can be orders of magnitude higher than the rotational energy possessed by molecular species in the same gas. Under such conditions, temperature is undefined. Nevertheless, in plasma research, temperature is commonly used in terms of a single plasma species with energies that may follow a Maxwell-Boltzmann distribution. For example electron temperature (Tₑ), given in units of electron-volts (eV), is commonly used to classify plasmas according to the kinetic energy possessed by electrons in the plasma.

In order to sustain a non-equilibrium state, non-thermal plasmas require constant energy input. In plasmas, electrons are most influenced by applied electric fields as they are charged and have masses that are significantly lower than the heavy particles. Therefore strong electric fields can be used to preferentially transfer energy to the electrons in the plasma. The most common methods of producing non-thermal plasmas at atmospheric pressure involve simply applying a high voltage between two electrodes placed close together.

Electrons in plasmas can undergo inelastic and elastic collisions with heavy particles. Inelastic collisions are chiefly responsible for generating excited and reactive species in the plasma, whilst elastic collisions cause the transfer of kinetic energy from electrons to heavy particles. Being out of equilibrium, non-thermal plasmas rapidly thermalize and reach equilibrium through elastic collisions of electrons with heavy particles. In fact, at atmospheric pressure (where the density of heavy particles is high and electron mean free paths are short), elastic collisions of electrons with heavy particles rapidly lead to heating of the gas. Electrical arcs are a good example of this type of process.

Many atmospheric pressure, low-temperature plasma sources have been developed and characterized in the past decade. The types of atmospheric pressure plasma sources are differentiated by the type of power input (DC, pulsed DC, radio-frequency, microwave) and energy coupling modes (capacitive, inductive). Comprehensive reviews of the various discharges and their operating conditions are available in literature.

Atmospheric pressure plasmas jets (APPJs) are low-temperature plasma sources that internally generate plasma that is subsequently blown out of the device by flowing gases. In addition to the nanoparticle deposition technique proposed by Gandhiraman described above, APPJs have also been used for surface cleaning, surface activation and etching.

The largest body of work concerning plasma jet deposition of metal containing conductive films is based on atmospheric pressure sputtering of a metallic target. This approach, first described by Nakahiro et al. (Effect of Hydrogen Reduction on Characteristics of Cu Thin-Films Deposited by RF-Driven Ar/H-2 Atmospheric Pressure Plasma Jet, Appl. Phys. Express, 2012, 5 (5), 3) for copper, employs a wire placed in a high temperature plasma to sputter Cu and deposit it beyond the jet orifice. Deposition rates of up to 40 nm/min were achieved with such a set-up. However a major drawback of this technique is the very high temperatures (>800 K ) and input power (>300 W) required for atmospheric pressure sputtering. The high temperature makes the process industrially challenging and limits the number of suitable substrates for deposition. They also note resistivity of the deposited material that is higher than that of bulk copper by two orders of magnitude, suggesting oxidation or porosity as the cause of high resistivity.

There is a need for atmospheric pressure plasma jet deposition techniques which offer improved methods for depositing materials onto a range of substrates and which provide simpler, more industrially viable processes.

### Summary of the Invention

At its most general, the present invention relates to processes for preparing a deposit on a substrate using atmospheric pressure plasma jet deposition, and apparatus for performing such processes.

A first aspect of the invention is a process for preparing a deposit on a substrate using atmospheric pressure plasma jet deposition, comprising:
feeding a solution comprising a dissolved metal precursor into a plasma jet, wherein the dissolved metal precursor comprises a precursor metal selected from Groups 2 to 16, with the proviso that the precursor metal does not comprise Mn; and
directing the plasma jet towards a surface of the substrate such that material from the plasma jet becomes deposited onto the surface of the substrate.

Where known processes employ a suspension of undissolved, solid material such as metallic nanoparticles, or sputtering from solid metal as a source of material for deposition, the present invention instead uses a solution comprising dissolved metal precursor as the source of material for deposition. Since the process is an additive manufacturing process, rather than a subtractive process, there is little or no wasted material.

The plasma in atmospheric pressure plasma jet deposition is a non-thermal plasma. As explained above, in a non-thermal plasma, species have degrees of freedom that are not in equilibrium with each other. For example, the kinetic energy possessed by the electrons in a non-thermal plasma can be orders of magnitude higher than the rotational energy possessed by molecular species in the same gas. As a result, although the "electron gas" in a non-thermal plasma may reach very high temperatures, the remainder of the gas (the ions and neutral atoms) remains "cold", for example in some cases having a temperature of less than 125 °C. No high-temperature post-treatment processing is needed because the deposit is sintered *in situ* at low temperature by the plasma jet. This means that the present process is more versatile and may be used for preparing deposits on a wide range of substrates which would be unsuitable in other high temperature processes such as sputtering or flame deposition.

The solution comprises the dissolved metal precursor and a solvent or solvent mixture.

The term "dissolved metal precursor" as used herein refers to a precursor to the deposit formation, which is dissolved in the solution. In other words, the dissolved metal precursor is made up of solvated atoms, molecules or ions, for example a solvated salt or a solvated molecular complex. The term "dissolved metal precursor" therefore does not encompass dispersions or colloids. In some embodiments, the dissolved metal precursor is made up of species having a molecular weight less than 1000 g/mol. The dissolved metal precursor comprises a precursor metal which is a precursor to the material which is deposited on the surface of the substrate during the atmospheric pressure plasma jet deposition process, i.e. the deposit is derived from the precursor metal in the dissolved metal precursor.

In some embodiments, the solution is an aqueous solution, i.e. the solvent is water or a major component of the solvent is water. This provides a process which uses little or no volatile organic compounds in the precursor, thereby ameliorating safety concerns and reducing the risk of contamination of the deposited material.

In some embodiments the aqueous solution comprises at least 50 wt% water, for example at least 55 wt%, at least 60 wt%, at least 65 wt%, at least 70 wt%, at least 75 wt%, at least 80 wt%, at least 85 wt%, at least 90 wt% or at least 95 wt% water. In some embodiments, the balance is the dissolved metal precursor.

In some embodiments, a solvent mixture is used. In some embodiments, the solvent mixture comprises or consists of water and one or more co-solvents. The one or more co-solvent may be selected for example to improve the deposition of material, or solubility of the metal precursor, or to improve the sustainability of the plasma jet.

In some embodiments, the one or more co-solvents comprise an organic solvent. In some embodiments, the one or more co-solvents comprise an alcohol or an alkane. In some embodiments, the one or more co-solvents are each independently selected from methanol, ethanol, hexane, cyclohexane, heptane and decane.

The solution may contain less than 0.5 wt% solid material, for example less than 0.4 wt%, less than 0.3 wt%, less than 0.2 wt%, less than 0.1 wt% or less than 0.05 wt%. The process provides precursor for deposit formation in the form of dissolved metal precursor rather than solid material. Suspensions of solid material have a short shelf-life due to the gradual settling of the solid component of the suspension over time, which makes the suspension no longer effective as a source of material. By contrast, the solution used herein has a very long shelf-life since it relies on the dissolved precursor as a precursor to the deposited material rather than suspended solid material. In some embodiments the solution contains less than 0.5 wt% solid particulate material, for example less than 0.4 wt%, less than 0.3 wt%, less than 0.2 wt%, less than 0.1 wt% or less than 0.05 wt%.

The solution which is used as a precursor to the deposit on the substrate comprises a dissolved metal precursor. The solution may comprise a single type of dissolved metal precursor or two or more different types of dissolved metal precursor. In some embodiments, the dissolved metal precursor comprises one or more of dissolved metal salts and dissolved metal complexes.

In some embodiments, the dissolved metal precursor comprises one or more dissolved metal salts, wherein the precursor metal is a precursor metal cation. The metal salt may comprise counter anions. In some embodiments, the dissolved metal precursor comprises a single type of dissolved metal salt, i.e. the dissolved metal precursor in the solution consists of a single type of dissolved metal salt. In some embodiments, the solution comprises a single type of precursor metal cation (i.e. the dissolved metal precursor comprise a single type of precursor metal cation along with one or more types of counter anion).

In some embodiments, the dissolved metal precursor comprises one or more dissolved metal complexes, for example organometallic complexes in which a precursor metal atom is coordinated to one or more organic species, or inorganic complexes, in which a precursor metal atom is coordinated to one or more inorganic chemical species (e.g. inorganic anions, such as CN⁻). Such a complex may be positively charged, negatively charged or of neutral charge. In some embodiments, the dissolved metal precursor comprises a single type of dissolved metal complex. In some embodiments, the dissolved metal precursor comprises a dissolved metal complex which comprises two or more metal atoms within the complex, each of the two or more metal atoms being different from the others (i.e. a heteroatom complex). In some embodiments, the dissolved metal precursor consists of a single type of dissolved metal complex. When the dissolved metal complex carries a charge, a counter-ion may be present and the identity of this counter-ion is not particularly limited. In some embodiments, when the complex is negatively charged, the counter-cation may comprise a metal counter-cation. The metal counter-cation may be selected from alkali metal ions, alkaline earth metal ions and transition metal ions. The metal counter-cation may be selected from alkali metal ions and alkaline earth metal ions. In some embodiments, when the complex is positively charged, the counter-anion may be selected from one or more of fluoride (F⁻), chloride (Cl⁻), bromide (Br⁻), iodide (I⁻), chlorate (ClO₃⁻), perchlorate (ClO₄⁻), hydroxide (OH⁻), hydride (H⁻), carbonate (CO₃²⁻), hydrogencarbonate (HCO₃⁻), acetate (CH₃COO⁻), phosphate (PO₄³⁻), sulfate (SO₄²⁻), nitrate (NO₃⁻) and formate (HCO₂⁻).

The term "concentration of precursor metal" used herein denotes the concentration of precursor metal *atoms* in the solution provided by the dissolved metal precursor. So, for example, a dissolved metal precursor which is a metal complex which contains two metal atoms per complex would provide a concentration of precursor metal which is double that of the concentration of the complex itself. For species, e.g. salts, containing a single precursor metal atom per salt molecule, the concentration of precursor metal and salt are equivalent.

The concentration of the precursor metal in the solution may be at least 0.001 M. Higher concentrations lead to a greater rate of deposit formation on the substrate surface, so such a concentration may help to provide more efficient deposition. In some embodiments, the concentration of the precursor metal in the solution is at least 0.002 M, for example at least 0.005 M, at least 0.01 M, at least 0.02 M, at least 0.05M, at least 0.10 M, at least 0.15 M, at least 0.20 M, at least 0.22 M, at least 0.25 M, at least 0.3 M, at least 0.31 M, at least 0.32 M, at least 0.33 M, at least 0.34 M, at least 0.35 M, at least 0.36 M, at least 0.37 M, at least 0.38 M, at least 0.39 M, at least 0.40 M, at least 0.45 M or at least 0.50 M.

It has been found that there is a correlation between the concentration of the precursor metal in the solution and the rate at which the deposit builds up on the substrate. As the concentration is increased, a greater quantity of deposit is delivered to the substrate surface in a given period. Higher concentrations such as those specified above may be preferred where an increased rate of deposit of material is desired.

There is no upper limit to the total concentration of precursor metal in the solution other than the natural saturation limit for the dissolved metal precursor in the solvent (taking into account the presence of any other dissolved species in the solution), and the absolute concentration limit will therefore depend upon the choice of solvent and metal precursor. Thus in some embodiments, the concentration of precursor metal in the solution is up to 100% saturation, for example up to 99% saturation, up to 98% saturation, up to 97% saturation, up to 96% saturation, up to 95% saturation or up to 90% saturation. In some embodiments, the concentration of the precursor metal in the solution is in the range from 0.001 M to 100% saturation, for example from 0.5 M to 100% saturation.

Lower concentrations of precursor metal may be preferred when slower deposition is desirable, for example to improve fine control over the amount or location of the deposit. Certain concentrations may also be desirable to provide specific deposit morphology. A lower concentration leads to lower surface roughness and higher connectivity within the deposit. A higher concentration leads to a larger deposited particle size, so greater surface roughness.

In some embodiments the solution contains a single dissolved metal precursor, for example a single species of precursor metal ion. This means that the amounts of any other metal ions in solution will be zero or negligible, for example less than 0.2 M, less than 0.15 M, less than 0.1 M, less than 0.05 M or less than 0.01 M. This enables the formation of a pure deposit of material on the substrate, for example a pure metal deposit.

The dissolved metal precursor comprises a precursor metal selected from Groups 2 to 16 of the periodic table, with the proviso that the precursor metal does not comprise manganese (Mn). The precursor metal may be a metal selected from Groups 2 to 6 or Groups 8 to 16. The precursor metal may be a metal selected from Groups 2 to 6 or Groups 8 to 15. The precursor metal may be a metal selected from Groups 2 to 6 or Groups 8 to 14. The precursor metal may be a transition metal selected from Groups 3 to 6 or Groups 8 to 12.

In some embodiments, the dissolved metal precursor comprises or consists of one or more of a transition metal salt and a transition metal complex. In such embodiments the precursor metal is a transition metal. In some embodiments, the transition metal salt or complex comprises one or more precursor metals selected from copper (Cu), ruthenium (Ru), rhodium (Rh), palladium (Pd), silver (Ag), rhenium (Re), osmium (Os), iridium (Ir), platinum (Pt), chromium (Cr), gold (Au) and mercury (Hg). In some embodiments, the transition metal salt or complex comprises one or more precursor metals selected from copper (Cu), ruthenium (Ru), rhodium (Rh), palladium (Pd), silver (Ag), osmium (Os), iridium (Ir), platinum (Pt), chromium (Cr) and gold (Au). In some embodiments, the transition metal salt or complex comprises one or more precursor metals selected from copper (Cu), silver (Ag) and gold (Au). In some embodiments, the transition metal salt is a copper salt. In some embodiments, the transition metal salt is a silver salt. In some embodiments, the transition metal complex is a gold complex.

In some embodiments the dissolved metal precursor comprises or consists of a transition metal salt. In some embodiments, the transition metal salt comprises one or more precursor metals selected from copper (Cu), ruthenium (Ru), rhodium (Rh), palladium (Pd), silver (Ag), rhenium (Re), osmium (Os), iridium (Ir), platinum (Pt), chromium (Cr), gold (Au) and mercury (Hg). In some embodiments, the transition metal salt comprises a single precursor metal selected from copper (Cu), ruthenium (Ru), rhodium (Rh), palladium (Pd), silver (Ag), rhenium (Re), osmium (Os), iridium (Ir), platinum (Pt), chromium (Cr), gold (Au) and mercury (Hg). In some embodiments, the transition metal salt comprises one or more precursor metals selected from copper (Cu), ruthenium (Ru), rhodium (Rh), palladium (Pd), silver (Ag), osmium (Os), iridium (Ir), platinum (Pt), chromium (Cr) and gold (Au). In some embodiments, the transition metal salt comprises a single precursor metal selected from copper (Cu), ruthenium (Ru), rhodium (Rh), palladium (Pd), silver (Ag), osmium (Os), iridium (Ir), platinum (Pt), chromium (Cr) and gold (Au). In some embodiments, the transition metal salt comprises one or more precursor metals selected from copper (Cu), silver (Ag) and gold (Au). In some embodiments, the transition metal salt comprises a single precursor metal selected from copper (Cu), silver (Ag) and gold (Au). In some embodiments, the transition metal salt consists of a single type of transition metal salt, i.e. a salt comprising a single type of precursor metal cation and a single type of anion.

In some embodiments the dissolved metal precursor comprises or consists of a transition metal complex. In some embodiments, the transition metal complex comprises one or more precursor metals selected from copper (Cu), ruthenium (Ru), rhodium (Rh), palladium (Pd), silver (Ag), rhenium (Re), osmium (Os), iridium (Ir), platinum (Pt), chromium (Cr), gold (Au) and mercury (Hg). In some embodiments, the transition metal complex comprises a single precursor metal selected from copper (Cu), ruthenium (Ru), rhodium (Rh), palladium (Pd), silver (Ag), rhenium (Re), osmium (Os), iridium (Ir), platinum (Pt), chromium (Cr), gold (Au) and mercury (Hg). In some embodiments, the transition metal complex comprises one or more precursor metals selected from copper (Cu), ruthenium (Ru), rhodium (Rh), palladium (Pd), silver (Ag), osmium (Os), iridium (Ir), platinum (Pt), chromium (Cr) and gold (Au). In some embodiments, the transition metal complex comprises a single precursor metal selected from copper (Cu), ruthenium (Ru), rhodium (Rh), palladium (Pd), silver (Ag), osmium (Os), iridium (Ir), platinum (Pt), chromium (Cr) and gold (Au). In some embodiments, the transition metal complex comprises one or more precursor metals selected from copper (Cu), silver (Ag) and gold (Au). In some embodiments, the transition metal complex comprises a single precursor metal selected from copper (Cu), silver (Ag) and gold (Au). In some embodiments, the transition metal complex consists of a single type of transition metal complex, i.e. a complex comprising a single type of precursor metal cation.

In some embodiments, the transition metal complex comprises a negatively charged transition metal complex, for example [Fe(CN)₆]³⁻. In some embodiments, the transition metal complex comprises [Fe(CN)₆]³⁻ along with a counter cation. In some embodiments the counter cation is selected from a metal cation and a complex cation. In some embodiments the metal cation is selected from alkali metal cations, alkaline earth metal cations and transition metal cations. In some embodiments the metal cation is an alkali metal cation, e.g. Na⁺ or K⁺. The complex cation may be selected from positively charged metal complexes, e.g. organometallic complexes. The complex cation may be selected from positively charged transition metal organometallic complexes, for example [Ru(bpy)₃]³⁺.

In some embodiments, the transition metal complex comprises a neutral transition metal complex. In some embodiments, the transition metal complex comprises a neutral gold complex, for example AuCl₄H.

Where the dissolved metal precursor comprises a dissolved metal salt and/or a positively charged metal complex, the choice of counter-anion is not particularly limited. Nevertheless, some suitable anions include fluoride (F⁻), chloride (Cl⁻), bromide (Br⁻), iodide (I⁻), chlorate (ClO₃⁻), perchlorate (ClO₄⁻), hydroxide (OH⁻), hydride (H⁻), carbonate (CO₃²⁻), hydrogencarbonate (HCO₃⁻), acetate (CH₃COO⁻), phosphate (PO₄³⁻), sulfate (SO₄²⁻), nitrate (NO₃⁻) and formate (HCO₂⁻). In some embodiments, the anion is sulfate. One type of anion or a mixture of two or more types of anion may be used. For example, to provide copper as a single metal ion, a mixture of copper sulfate and copper nitrate may be used.

In some embodiments the dissolved metal precursor is a copper salt. In some embodiments the dissolved metal precursor is selected from copper sulfate and copper formate. In some embodiments the dissolved metal precursor is a silver salt. In some embodiments the dissolved metal precursor is silver nitrate. In some embodiments the dissolved metal precursor is a gold complex. In some embodiments the dissolved metal precursor is hydrogen tetrachloro aurate (AuCl₄H).

In some embodiments the solution is an aqueous copper salt (e.g. copper sulfate) solution having a copper concentration of at least 0.001 M, for example at least 0.002 M, at least 0.005 M, at least 0.01 M, at least 0.02 M, at least 0.05 M, at least 0.10 M, at least 0.15 M, at least 0.2 M, at least 0.25 M, at least 0.3 M, at least 0.31 M, at least 0.32 M, at least 0.33 M, at least 0.34 M, at least 0.35 M, at least 0.36 M, at least 0.37 M, at least 0.38 M, at least 0.39 M, at least 0.40 M, at least 0.45 M or at least 0.50 M. In some embodiments the solution is an aqueous copper salt (e.g. copper sulfate) solution having a copper concentration of from 0.2 M to about 2.0 M, for example from 0.2 M to about 1.5 M, from 0.2 M to about 1.2 M, from 0.25 M to about 1.2 M, from 0.3 M to about 1.2 M, from 0.31 M to about 1.2 M, or from 0.35 M to about 1.2 M.

In some embodiments the solution is an aqueous silver salt (e.g. silver nitrate) solution having a silver concentration of at least 0.001 M, for example at least 0.002 M, at least 0.005 M, at least 0.01 M, at least 0.02 M, at least 0.05 M, at least 0.10 M, at least 0.15 M, at least 0.2 M, at least 0.25 M, at least 0.3 M, at least 0.31 M, at least 0.32 M, at least 0.33 M, at least 0.34 M, at least 0.35 M, at least 0.36 M, at least 0.37 M, at least 0.38 M, at least 0.39 M, at least 0.40 M, at least 0.45 M or at least 0.50 M. In some embodiments the solution is an aqueous silver salt (e.g. silver nitrate) solution having a silver concentration of from 0.2 M to about 2.0 M, for example from 0.2 M to about 1.5 M, from 0.2 M to about 1.2 M, from 0.25 M to about 1.2 M, from 0.3 M to about 1.2 M, from 0.31 M to about 1.2 M, or from 0.35 M to about 1.2 M.

The solution may contain only the solvent or solvent mixture and one or more dissolved metal precursors, however in some embodiments the solution may also contain one or more additional additives or preservatives to help stabilise the solution or optimise the process, and may also contain trace amounts of impurities. Suitable additives are known to the skilled person and may include acids to lower the pH thereby increasing the stability of the solution and/or increasing the solubility of the precursor, including mineral acids such as hydrochloric acid or sulfuric acid, and organic acids such as methanoic acid or ethanoic acid. Suitable preservatives are known to the skilled person and may include e.g. sodium azide.

In some embodiments the solution consists of the solvent or solvent mixture, one or more dissolved metal precursors and one or more optional additives or preservatives (and any inevitable trace impurities). In such embodiments the solution does not contain any additional components e.g. solids components.

The solution may be prepared by dissolving a metal-containing precursor compound, for example a metal salt or metal complex, in water in suitable ratios to obtain the desired concentration of precursor metal. In some embodiments a saturated solution is prepared initially by adding an excess amount of precursor compound (e.g. metal salt) to the solvent or solvent mixture, mixing to dissolve, and filtering to remove any undissolved precursor compound. This saturated solution may then be used as a feedstock to prepare more dilute solutions by the addition of further quantities of solvent or solvent mixture.

In the process of the invention a deposit is made on a substrate by feeding the solution containing the dissolved metal precursor into the plasma jet. In some embodiments, the solution is nebulised to produce an aerosol which is fed into the plasma jet. Without wishing to be bound by theory, it is believed that the plasma jet then carries the components of the aerosol to the surface of the substrate where they are deposited to form the deposit on the substrate. The nature of the deposit depends upon, among other factors, the composition of the aqueous solution and the composition of any other components which are fed into the plasma jet.

In some embodiments, the deposit on the surface of the substrate comprises a plurality of particles.

In some embodiments, the process comprises directing the plasma jet towards a surface of the substrate such that material from the plasma jet becomes deposited onto the surface of the substrate, and sintering the deposit to form a sintered deposit on the substrate. The sintering may occur in at least a portion of the deposit.

The deposit on the substrate may comprise a network of sintered particles, each particle originating from an aerosol droplet ejected from the nozzle. With conductive and semiconductor deposits, sintering may be achieved by passing high frequency current through the plasma onto the deposited film composed of fine particulate matter under the inert plasma working gas. The sintering and deposition process may happen simultaneously, or deposition passes with the plasma jet may be followed by specific sintering passes. High frequency current density is highest at the surface of the deposit due to skin effect and therefore the plasma jet effectively sinters the surface of the film with minimal thermal effects on the substrate. Furthermore, heating due to Joule heating is highest in areas with highest resistivity (i.e. contact points between nano/micro particles), therefore the sintering results in a highly connected deposit. The plasma jet may therefore be viewed as both a source of the particulate matter and also a fine gaseous electrode used to deliver alternating current to the deposit surface in a localized manner for sintering. In order to tune the thermal characteristics of the plasma jet while achieving stable plasma output, pulsed radio frequency may be used to keep the substrate temperature to a minimum while efficiently reducing and sintering the precursor material.

Thus in some embodiments the process comprises directing the plasma jet towards a surface of the substrate such that material from the plasma jet becomes deposited onto the surface of the substrate, and sintering at least a portion of the deposit using the plasma jet.

The solution may be fed to the plasma jet as an aerosol. Any suitable method and apparatus may be achieved to produce an aerosol from the aqueous solution. In some embodiments, the solution is aerosolized using one or more nebulisers. The one or more nebulisers may be independently selected from a spray nebuliser, concentric nebulizer and an ultrasonic nebuliser. Where more than one nebuliser is used, the multiple nebulisers may nebulise identical solutions or may be used to nebulise different solutions. For example, a first nebuliser may be used to provide a first aerosol comprising a first metal precursor and a second nebuliser may be used to provide a second aerosol comprising a second metal precursor. These first and second aerosols may then be mixed with each other after nebulisation and before feeding into the plasma jet.

In some embodiments, the average droplet size (D₅₀) of the aerosol is from 0.5 µm to 20 µm.

In some embodiments, the process further comprises providing a feed gas and mixing the feed gas with the aerosol to provide a mixture before feeding the mixture into the plasma jet. Such a feed gas provides a suitable vehicle to carry the aerosol containing the metal salt into the plasma jet. Furthermore, the feed gas may contain one or more reactive gases which react with the metal species to modify the composition of the deposit on the substrate. In some embodiments, the mixing of the feed gas and the aerosol takes place in a mixing chamber upstream of the plasma jet and downstream of the nebuliser. The skilled person will understand that the distance between such a mixing chamber and the plasma jet should be chosen to ensure that the aerosol and gas are mixed to provide a suitably homogeneous composition. Furthermore, the distance between the mixing chamber and the plasma jet may be chosen to determine the size of the droplets entering the plasma jet, since a greater distance will provide more drying and therefore smaller droplets. In some embodiments, a gas line of a length of from 1 to 5 m is provided between the mixing chamber and the plasma jet. This length of gas line ensures both good mixing and good drying of the aerosol before feeding into the plasma jet.

At least a portion of the feed gas may originate from the nebuliser, i.e. may be a gas which is used to nebulise the solution into an aerosol. A further portion of the feed gas may then be mixed with the gas/aerosol mixture after nebulisation. In some embodiments, the nebulising gas comprises Ar. In some embodiments, the portion of feed gas mixed with the aerosol/gas mixture after nebulization comprises He.

In some embodiments, the process further comprises drying the aerosol/gas mixture before feeding into the plasma jet. In some embodiments, this comprises drying the aerosol/gas mixture with a gas heater, dehumidifier or in-line dryer. Such drying acts to reduce the droplet size of the aerosol. Smaller aerosol droplet sizes are preferred as these lead to correspondingly smaller particle deposits on the substrate, and smaller particles achieve a smoother deposit, reduce the sintering temperature and increase interconnectivity between particles, thereby e.g. increasing conductivity for conductive (e.g. metallic) deposits. Furthermore consistent and uniform droplet size improves control over the deposition since the particle trajectory becomes easier to control.

Drying also reduces the quantity of water reaching the plasma jet, which ensures that the plasma jet is not extinguished during the process.

In some embodiments, the overall flow rate of gas through the plasma nozzle is from about 20 mL/min to about 600 mL/min, for example from about 30 mL/min to about 550 mL/min, from about 40 mL/min to about 500 mL/min, from about 50 mL/min to about 500 mL/min, from about 60 mL/min to about 450 mL/min, from about 100 mL/min to about 400 mL/min, from about 150 mL/min to about 350 mL/min or from about 200 mL/min to about 300 mL/min.

The rate of feeding of aerosol droplets into the plasma jet during the process may be from about 0.01 mL/min to about 0.2 mL/min, for example from about 0.01 mL/min to about 0.15 mL/min, from about 0.01 mL/min to about 0.10 mL/min, from about 0.01 mL/min to about 0.08 mL/min, from about 0.01 mL/min to about 0.06 mL/min or from about 0.01 mL/min to about 0.05 mL/min.

In some embodiments, the nebulising gas (e.g. Ar) flow rate is from about 10 mL/min to about 100 mL/min, for example from about 15 mL/min to about 90 mL/min, from about 20 mL/min to about 80 mL/min, from about 25 mL/min to about 70 mL/min, from about 30 mL/min to about 60 mL/min or from about 35 mL/min to about 50 mL/min.

The rate of nebulisation of the solution may be greater than the rate of feeding of aerosol into the plasma jet, with a quantity of the nebulised solution being recycled before feeding into the plasma jet to achieve the desired feeding rate into the jet. In some embodiments, the amount of solution nebulised during the process is from 0.5 mL/min to 5 mL/min, for example from 0.5 mL/min to 5 mL/min, from 0.5 mL/min to 4 mL/min, from 0.5 mL/min to 3 mL/min, from 0.5 mL/min to 2 mL/min, from 0.5 mL/min to 1.5 mL/min, from 0.6 mL/min to 1.4 mL/min or about 1 mL/min.

Without wishing to be bound by theory, it is believed that the high concentration of electrons within the plasma jet leads to the reduction of species within the aqueous solution after they are fed into the plasma jet. As a result, the invention provides a method of reducing a dissolved metal precursor to an elemental metal deposited on the substrate, even in the absence of additional reducing species in the feed gas.

As a result, the invention in some embodiments provides a process for preparing a metallic deposit on a substrate using atmospheric pressure plasma jet deposition, comprising:
feeding a solution comprising a dissolved metal precursor into a plasma jet, wherein the dissolved metal precursor comprises a precursor metal selected from Groups 2 to 16, with the proviso that the precursor metal does not comprise Mn; and
directing the plasma jet towards a surface of the substrate such that elemental metal becomes deposited onto the surface of the substrate.

The feed gas comprises inert or reactive gas or gas mixture comprised of inert and reactive gases. In some embodiments, the feed gas comprises a noble gas. In some embodiments, the feed gas comprises one or more of He and Ar. In some embodiments, the feed gas comprises one or more of He and Ar.

In some embodiments, in addition to the inert gas the feed gas further comprises a reducing gas. In some embodiments the reducing gas is selected from hydrogen and methane. The reducing gas may be mixed with the gas/aerosol mixture after nebulisation of the aerosol. Without wishing to be bound by theory, it is believed that the presence of a reducing gas in the feed gas accelerates the process of reduction of the metal species within the plasma jet to the elemental metal and counteracts the oxidising effect of any moisture present in the feed gas. The reducing gas (e.g. hydrogen) may be present in the feed gas at a concentration of up to around 10 vol%, for example up to around 9 vol%, up to around 8 vol%, up to around 7 vol%, up to around 6 vol% or up to around 5 vol%, based on total feed gas volume. In some embodiments the feed gas comprises hydrogen in an amount of from 0.5 vol% to 5 vol%, based on total feed gas volume. Hydrogen is a preferred reducing gas since it provides clean, fast reduction of the metal precursor.

Thus in some embodiments, the deposit on the substrate is a metal deposit (i.e. a deposit of material which comprises or consists of elemental metal). The metal deposit is a derivative of the dissolved metal precursor in the solution, for example a product of the reduction of the dissolved metal precursor. Such a metal deposit may be produced from the metal precursor dissolved in the solution by providing reducing conditions within the plasma jet. For example, the high concentration of electrons within the non-thermal plasma jet alone may contribute to the reduction of the metal precursor and the additional presence of hydrogen may contribute further to this reduction.

In some embodiments, the feed gas consists of an inert gas, for example helium or argon. In some embodiments, the feed gas consists of one or more inert gases and a reducing gas such as hydrogen or methane, for example a mixture of helium and reducing gas, a mixture of argon and reducing gas or a mixture of helium, argon and reducing gas.

In an alternative embodiment, the feed gas may comprise an oxidising gas or oxidising gas mixture. In this way, the composition of the deposit may be modified, for example to contain oxides. The metal precursor in the solution may be oxidised by the oxidising gas to produce the corresponding metal oxide deposit on the surface of the substrate. For example, when a copper salt is present in the solution, the copper may be oxidised to provide a copper oxide deposit on the substrate.

In some embodiments, the plasma jet is ignited and stabilised by an electrode connected to a radio frequency generator. In some embodiments the radio frequency signal from the generator is pulsed, thereby providing a pulsed plasma jet. The radio frequency generator may provide a duty cycle of from 10 to 40%. Duty cycle is defined as the ratio between the pulse "on" time and the period of the period of the pulse waveform. It has been found that an RF power source provides a plasma jet of lower temperature at a given power input than that produced by other power sources such as DC, thereby providing a more stable and versatile deposition process. It has been found that the provision of a pulsed RF signal reduces the temperature of the plasma further which retaining good stability of the plasma jet, thereby increasing the versatility of the process and allowing a wider range of substrates to be used for receiving the deposit. In some embodiments, the RF driving voltage is from 1 MHz to 100 MHz, for example from 1 MHz to 90 MHz, from 1 MHz to 80 MHz, from 1 MHz to 70 MHz, from 1 MHz to 60 MHz, from 1 MHz to 50 MHz, from 1 MHz to 40 MHz, from 1 MHz to 30 MHz, from 5 MHz to 30 MHz, from 10 MHz to 30 MHz, from 10 MHz to 25 MHz, from 10 MHz to 20 MHz, or about 13 MHz.

The deposit may comprise a material selected from a conductive, semiconducting or insulating material. In some embodiments, the deposit is a track, layer or coating selected from a conductive, semiconducting or insulating track, layer or coating.

In some embodiments, the deposit on the substrate comprises a metallic track, layer or coating. In some embodiments, the deposit on the substrate comprises a metallic track. For example, the deposit may comprise a copper track. Such tracks may find use in a wide range of applications including but not limited to interconnects, RFID and PCB applications photonic devices or any other application where a metallic track is required on the surface of a substrate, or where magnetic properties of a track are desirable. Since the present invention permits deposition on a wider range of substrates, the fields of application are correspondingly broad. In some embodiments, the metallic track is a metallic conductive track for use in applications where conductivity of the track is essential, e.g. PCB applications.

In some embodiments, two or more different metal precursors are fed into the plasma jet. In this way, it is possible to prepare an alloy deposit on the surface of the substrate due to the simultaneous reduction and deposit of an intimate mixture of the multiple different metal species on the substrate. The present process may be used to deposit a true alloy onto a substrate by feeding multiple different metal precursors into the plasma jet. The composition and properties of the alloy may be tailored by adjusting the identities and relative proportions of metal precursors fed into the plasma jet. In some embodiments, the solution comprises two or more different metal precursors, such that an intimate mixture of the different metal precursors is fed into the plasma jet. In some embodiments, the process provides two or more solutions comprising two or more different respective metal precursors, and two or more nebulisers which nebulise the two or more respective solutions. In this way, multiple aerosol streams containing different metal precursors are provided and may be mixed before feeding into the plasma jet. In some embodiments, the solution comprises two different metal precursors respectively comprising different precursor metals and a binary alloy may be deposited onto the substrate. In some embodiments, the solution comprises three different metal precursors respectively comprising three different precursor metals and a ternary alloy may be deposited onto the substrate. Herein, the term "alloy" may refer to a solid solution of two or more metal elements forming a single phase in which all metallic grains are of the same composition. The details of the dissolved metal precursor described above apply independently to each dissolved metal precursor when two or more different dissolved metal precursors are used.

The alloy may be selected from any desired alloy and the metal precursors may be selected accordingly. Not limiting examples of alloys which may be prepared by the process include alloys related to stainless steel (e.g. containing iron and one or more of nickel, chromium and molybdenum and optionally further components), duralumin (aluminium, copper, magnesium, manganese), mangaloy (manganese and iron), magnox (magnesium and aluminium) and nichrome (nickel and chromium).

In some embodiments, the deposit on the substrate comprises a coating. In some embodiments, the deposit on the substrate comprises a functional coating. In some embodiments, the deposit on the substrate comprises a coating which imparts the substrate with properties selected from antibacterial properties, magnetic properties, optical properties, sensor properties, catalytic properties and anti-corrosion properties. In some embodiments, the deposit provides the substrate with surface decoration comprising nanoparticles. Nanoparticle surface decoration may be used to provide a range of properties including catalytic properties. The nanoparticles may comprise one or more of CuO, Pt or Mo. In some embodiments, the deposit on the substrate comprises a silver coating. Such silver coatings may be used to provide a substrate with antibacterial properties.

In some embodiments, the deposit on the substrate comprises a conformal coating, for example to provide anti-corrosive properties.

In some embodiments, the process comprises depositing a first layer of a first material onto the surface of the substrate, followed by depositing a second layer of a second material onto the first layer, wherein the first and second materials are different. In this way, a laminate structure may be deposited on the substrate which may be desirable when the properties of the material in contact with the substrate should differ from those of the material on the surface, in contact with the atmosphere. For example, the second material may have greater anti-corrosion properties than the first material, and/or the first material may have greater adhesive properties with respect to the substrate than the second material.

In some embodiments, the first material is a material which exhibits greater adhesion to the surface of the substrate than the second material. In this way, a material which needs to be deposited onto a substrate to provide a particular function (the second material) may be deposited on the substrate with a greater level of adhesion than if the second material were deposited directly onto the substrate.

In some embodiments, the first material is silver. Silver is a metal with relatively high adhesiveness to a wide range of substrates, including smooth substrates such as glass. Thus silver may be used as a "base" layer which adheres well to the substrate, and further materials may then be deposited onto the surface of the silver layer to improve the overall adhesion of these further materials to the substrate. For example, a first layer of silver may be deposited onto a substrate followed by a second layer of copper, onto the surface of the first layer, to provide a copper conductive track. The copper conductive track may then exhibit greater adhesion to the substrate due to the intervening silver layer. The first layer of silver may be deposited by feeding a solution containing a dissolved silver precursor, such as a dissolved silver salt (e.g. silver nitrate) or silver complex, into the plasma jet. The second layer of copper may be deposited by later feeding a solution containing a dissolved copper precursor, such as a dissolved copper salt (e.g. copper sulfate) or copper complex, into the plasma jet.

The skilled person will understand that the above principle may be applied to produce deposits with two or more layers, for example three, four or five layers, where this would be desirable.

A wide range of substrates may be used to receive the deposit from the atmospheric pressure plasma jet deposition process. In some embodiments, the substrate is a planar substrate. In some embodiments, the substrate is a three-dimensional substrate. In other embodiments the surface of the substrate may be curved. In some embodiments the surface of the substrate is rough. In some embodiments, the surface of the substrate comprises a material selected from plastic, metal, ceramic, biological material and glass. In some embodiments, the surface of the substrate comprises plastic such as PTFE, PET or Kapton. In some embodiments, the surface of the substrate comprises metal. In some embodiments, the surface of the substrate comprises ceramic. In some embodiments, the surface of the substrate comprises biological material, for example chitin or keratin. In some embodiments, the surface of the substrate comprises glass or PTFE. In some embodiments, the substrate is selected from glass and PTFE.

The plasma jet and the surface of the substrate may be fixed relative to one another during the deposition process, thereby producing static deposits in a single position. However the process may further comprise translating the substrate relative to the plasma jet during the plasma deposition to produce a one- or two-dimensional deposit on the surface of the material. In some embodiments the substrate is translated along a single axis thereby producing a one-dimensional deposit on the substrate (e.g. a metallic conductive track). In some embodiments, the substrate is translated along two axes thereby producing a two-dimensional deposit on the substrate (e.g. a coating).

Translation of the substrate may be achieved by positioning the substrate on a positioning stage which is movable relative to the plasma jet. The jet or the substrate may be translated or rotated around three axes for conformal coatings of curved or 3D substrates. Such positioning stages are well-known to the skilled person and a non-limiting example is supplied by Physik Instrumente.

In some embodiments, translation of the substrate is computer-controlled.

The skilled person will of course understand that an alternative to translation of the substrate is translation of the plasma jet apparatus, or translation of both simultaneously.

In some embodiments, the translation of the substrate relative to the plasma jet is carried out at a speed of at least 0.1 mm/s, for example at least 0.2 mm/s, at least 0.3 mm/s, at least 0.4 mm/s, at least 0.5 mm/s, at least 0.6 mm/s or at least 0.7 mm/s. The translation speed may be up to 5 mm/s, for example up to 4.5 mm/s, up to 4 mm/s, up to 3.5 mm/s, up to 3 mm/s, up to 2.5 mm/s, up to 2 mm/s or up to 1.5 mm/s. The translation speed may be from 0.1 mm/s to 5 mm/s, for example from 0.7 mm/s to 1.5 mm/s. The exact choice of translation speed will depend upon a number of factors including the concentration of the metal ion solution, as explained in more detail below.

The substrate may be placed at a distance of from 0.05 mm to 5 mm below the outlet of the nozzle of the plasma jet, for example from 0.3 mm to 1.0 mm, from 0.4 mm to 0.8 mm or from 0.5 mm to 0.75 mm.

When metallic conductive tracks are prepared according to the process of the invention, the resistivity (or conductivity) of the finished track depends upon a number of factors, including (a) the concentration of precursor metal in the precursor solution, and (b) the amount of time spent by the plasma jet at a given position relative to the substrate. As the concentration of precursor metal in the solution increases, the conductivity of the track will also tend to increase (resistivity will fall) when all other variables are kept constant. Furthermore, as the amount of time spent by the plasma jet at a given position relative to the substrate increases, the conductivity of the track will also tend to increase (resistivity will fall) when all other variables are kept constant.

Plasma jet parameters will also influence the conductivity of the deposited track. For example, changing the gas flow rate, RF generator duty cycle or power, or nozzle geometry would be expected to influence the amount of material deposited and extent of sintering within the deposit, and thereby the conductivity of the track.

Thus it is possible to tailor the final resistivity of the deposit by adjusting (a) the concentration of precursor metal in the solution, and/or (b) the amount of time spent by the plasma jet at a given position relative to the substrate, and/or (c) properties of the plasma, such as gas flow, duty cycle, RF power, nozzle diameter, etc.. Item (b) may be effectively adjusted by changing the translation speed of the plasma jet relative to the substrate, and/or by changing the number of passes over a given position while keeping translation speed constant. A greater translation speed results in a reduced amount of time spent at a given position. A greater number of passes over a given position results in an increased amount of overall time spent at that position.

The process of the invention provides a means to produce a metallic conductive track of very low resistivity. In some embodiments, the resistivity of the deposit is below 50 Ω cm⁻¹, for example below 40 Ω cm⁻¹, below 30 Ω cm⁻¹, below 20 Ω cm⁻¹, below 10 Ω cm⁻¹, below 5 Ω cm⁻¹, below 1 Ω cm⁻¹ or below 0.5 Ω cm⁻¹.

A third aspect of the invention is apparatus for atmospheric pressure plasma jet deposition of a deposit on a substrate, the apparatus comprising:
a feed solution comprising a dissolved metal precursor, wherein the dissolved metal precursor comprises a metal selected from Groups 2 to 16, with the proviso that the dissolved metal precursor does not comprise Mn;
a plasma jet generator which generates a plasma jet directable towards the substrate; and
means to direct the feed solution into the plasma jet.

The feed solution may be held in a suitable container or vessel provided with a liquid outlet. The liquid outlet may be in fluid communication with a nebuliser, for example a spray nebuliser or ultrasonic nebuliser, to convert the liquid solution into an aerosol.

In some embodiments, the average droplet size (D₅₀) of the aerosol is from 0.5 µm to 20 µm.

The plasma jet generator of the apparatus which may be used in the process according to the invention may comprise a nozzle through which the plasma jet is ejected and an electrode to effect the ignition and stabilisation of the plasma jet.

The nozzle may comprise a capillary which tapers to provide a relatively narrow outlet for the plasma jet. A suitable size of capillary may be chosen by the skilled person. For example, a capillary of internal diameter from 1.0 to 5.0 mm may be used, for example from 1.2 to 1.5 mm. The diameter of the nozzle outlet may be from 0.05 mm to 1 mm, for example from 0.3 mm to 0.7 mm. The capillary and outlet may comprise glass, for example borosilicate glass, or any other suitable dielectric material such as ceramic or a thermostable polymer-based material. In some embodiments the capillary has a length of from 10 mm to 60 mm, for example from 20 mm to 50 mm.

A feed gas outlet may be provided in fluid communication with the nozzle, such that feed gas may pass from the feed gas outlet into the capillary and eventually out of the nozzle outlet during the process. One or more gas sources may be provided which supply gas to the feed gas outlet, for example one or more pressurized gas sources.

The apparatus may comprise an electrode to effect the ignition and stabilisation of the plasma jet. In some embodiments, the electrode comprises a tungsten electrode. In some embodiments the electrode is an elongate electrode in the form of a rod which is placed substantially axially within the capillary of the nozzle. The electrode may be positioned centrally within the capillary. In some cases a cylindrical conductive grounded electrode may be positioned outside the capillary, co-axially with the rod electrode.

In some embodiments, the electrode is an elongate electrode having a maximum external diameter smaller than the internal diameter of the capillary, for example a maximum external diameter of from 0.1 mm to 0.5 mm, for example from 0.2 mm to 0.3 mm.

The electrode is powered by providing an electrical connection to a suitable power source. Suitable power sources include direct current (DC), pulsed DC, radiofrequency (RF) and microwave.

In the process of the invention the electrode is preferably connected to a radiofrequency (RF) generator as power source. It has been found that an RF power source provides a plasma jet of lower temperature at a given power input than that produced by other power sources such as DC, thereby providing a more stable and versatile deposition process.

In some embodiments, the RF driving voltage is from 1 MHz to 100 MHz, for example from 1 MHz to 90 MHz, from 1 MHz to 80 MHz, from 1 MHz to 70 MHz, from 1 MHz to 60 MHz, from 1 MHz to 50 MHz, from 1 MHz to 40 MHz, from 1 MHz to 30 MHz, from 5 MHz to 30 MHz, from 10 MHz to 30 MHz, from 10 MHz to 25 MHz, from 10 MHz to 20 MHz, or about 13 MHz.

Suitable RF generators include the 13.56 MHz generator manufactured by Coaxial Power UK, but other options will be apparent to the skilled person.

In some embodiments the RF generator is connected to the electrode via a matching network, such as an L topology to enable the electrode connection. In this way the impedance mismatch between the plasma jet and the RF generator output is minimised which ensures efficient power transfer from the generator to the plasma jet.

The apparatus may further comprise a movable positioning stage on which the substrate may be placed. The stage may be movable in two dimensions relative to the nozzle, allowing the position of the deposit to be determined based on the part of the substrate which lies directly below the nozzle outlet. The positioning stage may be controlled by a suitable computer program.

In preferred embodiments the RF generator output to the electrode is pulsed. It has been found that the provision of a pulsed RF signal reduces the temperature of the plasma further which retaining good stability of the plasma jet, thereby increasing the versatility of the process and allowing a wider range of substrates to be used for receiving the deposit. A pulsed signal may be provided by including a pulse generator in the circuit, as will be understood by the skilled person.

In some embodiments the pulse frequency is from 0.1 to 30 kHz, for example from 1 to 30 kHz, from 5 to 30 kHz, from 10 to 30 kHz, or from 15 to 25 kHz. In some embodiments, the duty cycle (on time) of the RF generator and thereby the plasma jet is from 10 to 40%, for example from 15 to 30%, or from 20 to 30%, for example around 25%. This means that for every on/off cycle of the RF generator, the plasma jet will be "on" for 25% of the time and "off" for 75% of the time. Using the specific example of a 20 kHz pulse frequency, this will result in a 12.5 µs plasma jet pulse.

In the process of the invention, feed gas may be supplied from one or more feed gas sources and solution may be supplied from a solution source. The solution may then be nebulised to provide an aerosol as described earlier. A mixing manifold may be provided to mix the one or more feed gases and the nebulised metal salt solution.

In some embodiments the apparatus further comprises an aerosol drying means to dry the aerosol between the nebuliser and the nozzle. The drying means may comprise a heater, for example an in-line dryer or a gas heater. The drying means may comprise a dehumidifier. Such drying means provide a way to reduce the droplet size of the aerosol.

In some embodiments the apparatus comprises a gas line of a length of from 1 to 5 m upstream of the nozzle through which a mixture of feed gas and aerosol passes. Providing this length of gas line ensures good mixing and good drying of the gas and aerosol before feeding into the plasma jet, for optimum properties of the deposit.

The feed gas and nebulised solution may then be fed into the nozzle via the feed gas outlet. The power supply to the electrode within the nozzle may be switched on, which will cause the ignition of the atmospheric pressure plasma jet and its ignition from the nozzle outlet. Material within the plasma jet provided by the gas/aerosol mixture will then become deposited on a substrate which is located directly below the nozzle outlet. The substrate may be held in place on a movable positioning stage. Movement of the positioning stage in one linear direction during the deposition may be used to provide a linear deposit, for example of a metallic conductive track.

Ignition of the plasma may occur in the presence or absence of the nebulised solution, but in general requires the presence of the inert gas. So, in some embodiments inert gas is supplied to the nozzle and power is then supplied to the electrode to ignite the plasma. The nebulised solution may be mixed into the initial inert gas stream which is supplied to the nozzle before ignition, or may be fed into the inert gas stream at some later point in time.

A fourth aspect of the invention is a deposit on the surface of a substrate obtained or obtainable by a process according to the first aspect. A fifth aspect of the invention is a substrate comprising a deposit on a surface thereof, wherein the deposit is obtained or obtainable by a process according to the first aspect.

In some embodiments, the substrate is a component of an electronic device, antenna or chip.In some embodiments, the surface of the substrate is planar. In other embodiments the surface of the substrate may be curved. In some embodiments the surface of the substrate is rough. In some embodiments, the surface of the substrate comprises a material selected from plastic, metal, ceramic, biological material and glass. In some embodiments, the surface of the substrate comprises plastic such as PTFE, PET, acrylic or Kapton. In some embodiments, the surface of the substrate comprises metal. In some embodiments, the surface of the substrate comprises ceramic. In some embodiments, the surface of the substrate comprises biological material, for example chitin or keratin.

In some embodiments, the surface of the substrate comprises glass, polyimide (e.g. Kapton), acrylic or PTFE. In some embodiments, the substrate comprises glass or PTFE. In some embodiments, the substrate consists of glass or PTFE. In some embodiments, the substrate is a printed circuit board.

A sixth aspect of the invention is an electronic device comprising the substrate according to the fifth aspect.

Another aspect of the invention provides a process for preparing a deposit on a substrate using atmospheric pressure plasma jet deposition, comprising:
feeding a solution comprising a dissolved metal precursor into a plasma jet, wherein the dissolved metal precursor comprises a precursor metal, wherein the concentration of the precursor metal in the solution is at least 0.2 M; and
directing the plasma jet towards a surface of the substrate such that material from the plasma jet becomes deposited onto the surface of the substrate.

In some embodiments of this aspect the concentration of the precursor metal in the solution is at least 0.25 M, for example at least 0.30 M, at least 0.31 M, at least 0.32 M, at least 0.33 M, at least 0.34 M, at least 0.35 M, at least 0.4 M or at least 0.5 M.

### Description of the Figures

Figure 1 shows a schematic drawing of the plasma jet deposition apparatus used in the present invention.
Figure 2 shows a schematic drawing of the plasma jet nozzle used in the present invention.
Figure 3 shows a schematic diagram of the plasma jet deposition apparatus including the aerosol and electrical supply used in the present invention
Figure 4 shows the plasma driving waveforms used to generate plasma in the plasma jet deposition apparatus.
Figure 5 shows a diagram of the concentric nebulizer aerosol generating apparatus.
Figure 6 shows a diagram of the ultrasonic aerosol generating apparatus.
Figure 7 shows a photograph of copper tracks being deposited on a glass surface using the plasma jet deposition apparatus.
Figure 8 shows plots of the measured resistivity of copper tracks deposited from various concentrations of copper sulphate solution, as the number of passes of the plasma jet increases.
Figure 9 shows scanning electron micrographs (SEM) of copper tracks deposited onto glass from copper sulphate precursor using the plasma deposition apparatus.

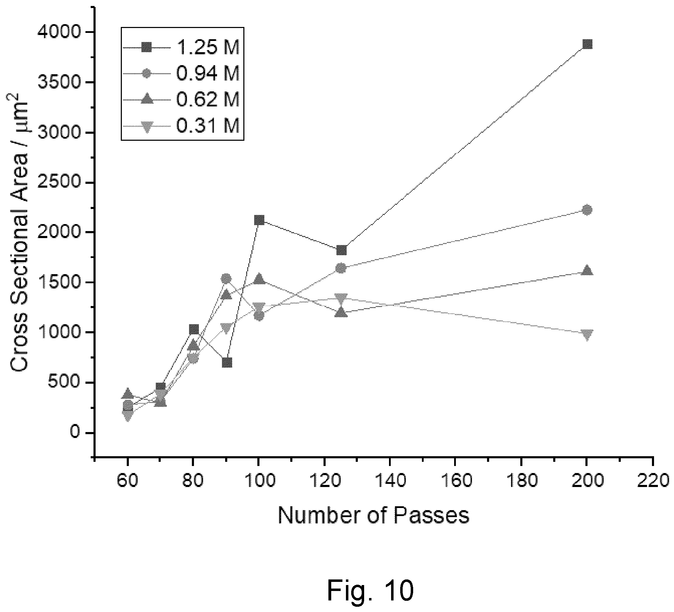

Figure 10 shows a plot of calculated cross sectional areas of the plasma printed tracks deposited using precursor solutions of increasing concentration. The concentrations are given in the inset tables
Figure 11 shows an example x-ray photoelectron spectrum (low resolution survey spectrum) collected from a sample film deposited at 25% duty cycle from 1.25 M CuSO₄ solution for 120 s, with major peaks identified.
Figure 12 shows the deconvolution of the Cu 2p XPS spectrum of copper tracks deposited with 1.25 M CuSO₄ and at 25% duty cycle at 120 seconds of deposition duration. The associated relative peak areas are given in the inset tables.
Figure 13 shows stacked Raman spectra taken from the copper track surface at increasing deposition durations. Normalized intensities are plotted.
Figure 14 shows Raman spectra of cuprous deposits obtained with different concentrations of H₂ in plasma gas.
Figure 15 shows scanning electron micrographs of copper deposited on polyimide using copper formate precursor using the plasma deposition apparatus.
Figure 16 shows scanning electron micrographs of silver deposited on acrylic using silver nitrate precursor using the plasma deposition apparatus.
Figure 17 shows scanning electron micrograph of gold deposit on glass using hydrogen tetrachloroaurate precursor using the plasma deposition apparatus.

Aspects and embodiments of the present invention will now be discussed in the following examples. Further aspects and embodiments will be apparent to those skilled in the art. All documents mentioned in this text are incorporated herein by reference.

### Experimental setup

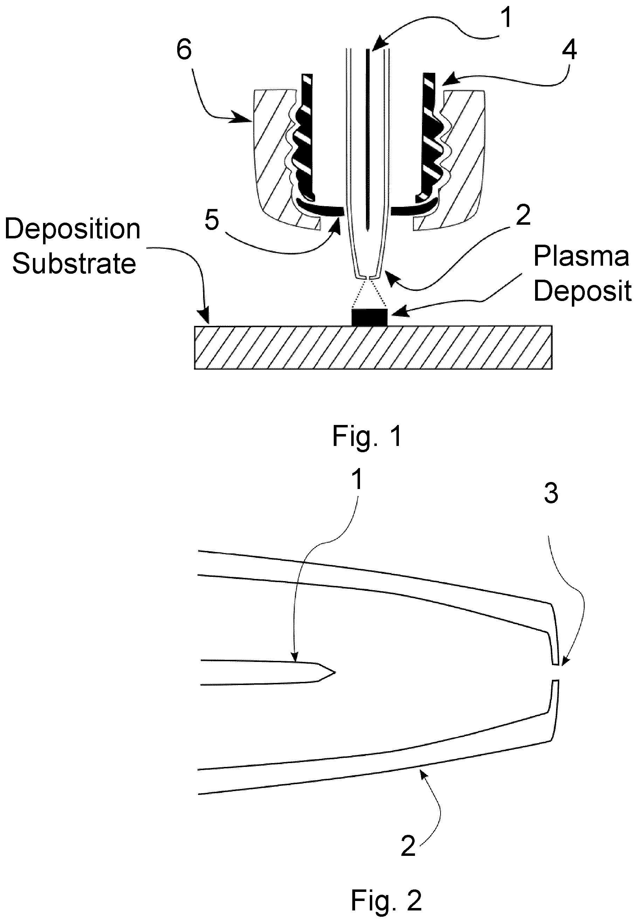

The plasma jet apparatus used in the following examples is shown in Figure 1. The plasma jet apparatus includes a powered tungsten electrode 1 of 0.25 mm diameter placed centrally in a 40 mm long capillary tube 2 of 1.4 mm inner diameter. One end of the capillary tapers down to 1 mm, with a 0.5 mm diameter orifice present at the end to serve as the plasma nozzle 3, shown in more detail in Figure 2. The capillary is mounted in a larger borosilicate glass tube 4 (20 mm O.D.) through a rubber septum 5 in contact with a screw-thread cap 6 with the nozzle end facing outwards. Working gas is introduced into the plasma jet apparatus via a gas inlet.

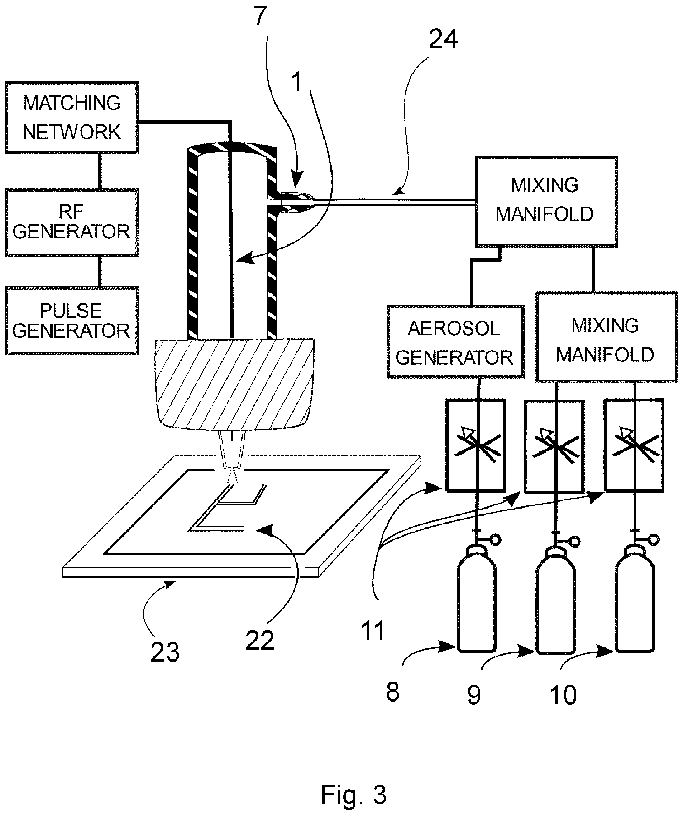

A schematic depiction of the deposition system is given in Figure 3. Hydrogen, helium and argon gas sources were used. The hydrogen concentrations used for the experiments ranged from 0 to 5 vol% of the total amount of hydrogen, argon and helium. A typical feed gas composition was around 5 vol% hydrogen, 35 vol% helium and 60 vol% argon. The overall gas flow rate through the nozzle during the experiments varied from 50 mL/min up to 500 mL/min, with a typical overall gas flow rate being 200 mL/min. All gases were fed from high pressure cylinders 8, 9, 10 through computer-controlled digital mass flow controllers 11 (Brooks Instrument) to maintain the chosen ratio.

Two different types of nebulizer were used in the experiments to nebulize the metal precursor solutions, "Nebulizer A" and "Nebulizer B".

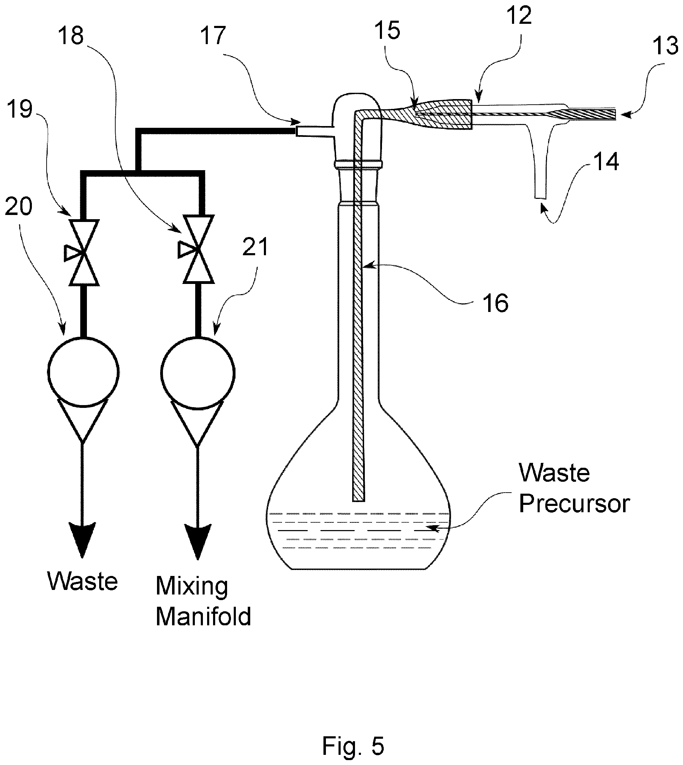

Nebulizer A was a concentric nebulizer 12 (Meinhard Type K), shown in Figure 5. The solution was fed into a capillary through the liquid inlet 13, the capillary was concentric with a glass tube connected to a pressurized gas inlet 14 through which argon was flown at a constant flow rate of 40 mL/min. The capillary and the outer tube were open on one end which serves as the aerosol nozzle 15. The fast-flowing gas around the nozzle causes the liquid inside the capillary to break into droplets that nominally range from 1 to 10 µm in size. The droplets were ejected from the nebulizer nozzle. The aerosol was injected directly into a large round bottom flask through a dip tube 16 that reaches nearly to the bottom. The larger droplets coalesce in the dip tube and collect at the bottom of the flask whereas the smaller droplets travel back up the neck and out of the flask through the aerosol outlet 17.

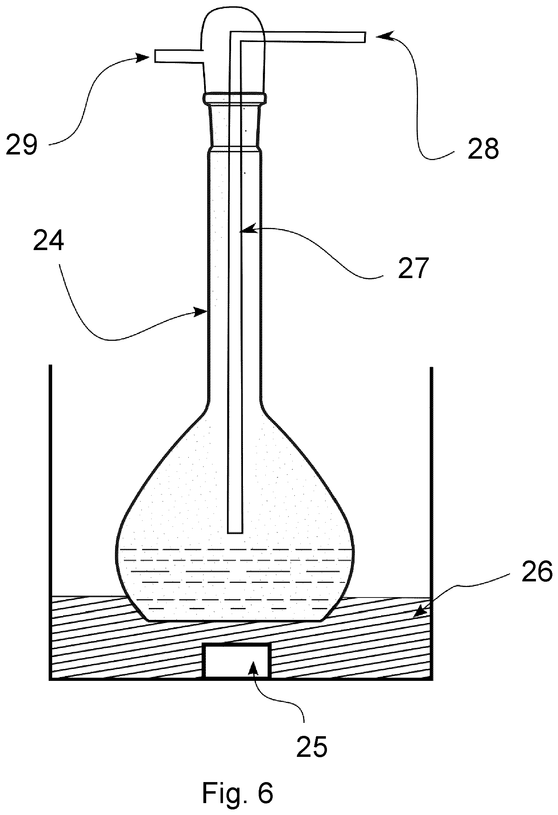

Nebulizer B was an ultrasonic nebulizer, shown in Figure 6. A long necked (30 cm) round bottom flask 24 was positioned in a ultrasonic nebulizer bath. The nebulizer bath consisted of a 20 W, 1.6 MHz piezoelectric atomizer element 25 positioned under 3 cm depth of distilled water acting as a sonic transfer medium 26. The round bottom flask was positioned directly above the atomizer element at a distance of 1.2 cm. Upon energizing the piezoelectric element, atomized solution was generated within the flask.

A dip tube 27 was inserted into the round bottom flask through the flask neck, positioned approximately 1 cm above the liquid level to introduce the aerosol carrier gas. Carrier gas was introduced through the gas inlet 28 and then flown up through the neck of the flask and through an outlet 29 positioned at the top of the flask.

The argon flow containing aerosol was then sent through a flow divider made up of two needle valves 18, 19 and two rotameters 20, 21. 60% of that flow was diverted and bubbled through water to recover the copper sulfate feedstock (denoted "waste" in Figure 5). The remaining 40% was mixed close to the flow divider exit in a wet mixing manifold with a dry mixture of hydrogen and helium which had been mixed in a dry mixing manifold. 2 metres of tubing 24 led from the wet mixing manifold to the plasma jet, to ensure good drying and mixing of the aerosol and gas mixture. The flow divider was used to adjust the amount of aerosol in the final plasma jet gas mixture. Gas was passed through the capillary where it was ignited and ejected from the nozzle onto the substrate 22 directly underneath. The jet used in this work produces dielectric barrier discharge plasma. The deposition substrate 22 serves as the dielectric barrier between the ground and the powered electrode.

Figure 3 shows a schematic diagram of the electrical circuit used in the apparatus. The powered electrode is connected, via an L topology matching network, to a 13.56 MHz RF Generator (Coaxial Power UK). The generator supplies the power required for sustaining the plasma. The matching network is used to minimize the impedance mismatch between the plasma jet and the 50Ω generator output, ensuring efficient power transfer from the generator to the jet.

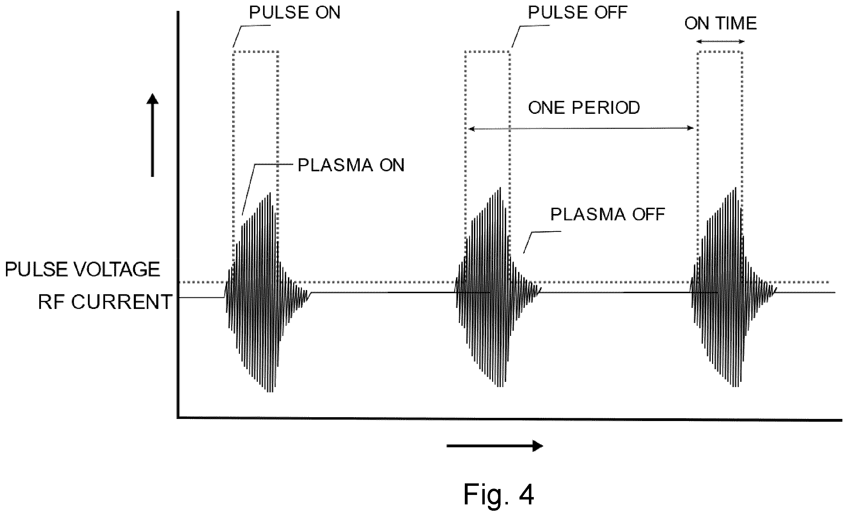

The RF generator output is modulated via a pulse generator using pulse width modulation. The pulse voltage and RF current waveforms that drive the apparatus are given in Figure 4. The RF output is enabled on the rising edge of the pulse waveform, the RF output is disabled on the falling edge of the pulse waveform. This results in discrete pulses of high voltage radio frequency on the electrode, igniting the plasma. The period of the pulse waveform is defined as the time elapsed between two rising edges of the pulse generator waveform. The frequency is defined as the inverse of the period. The duty cycle is given by the ratio between the on time and the period of the pulse waveform.

Plasma printing was started by placing the glass substrate on the positioning stage 23 and turning on the pulse generator, RF generator and working gas flow.

### Example 1 - Plasma Printing of Conductive Copper Tracks on Glass Surfaces

Copper sulfate solution feedstock was aerosolized with the nebulizer system shown in Figure 5, using argon feed gas. The copper sulfate solution was prepared by mixing an excess amount of copper sulfate in deionized water and mixing to achieve a saturated salt solution. This 100% saturated solution was then filtered to remove the excess undissolved copper sulfate. To prepare solutions of lower copper concentration, this solution was diluted with deionized water as necessary.

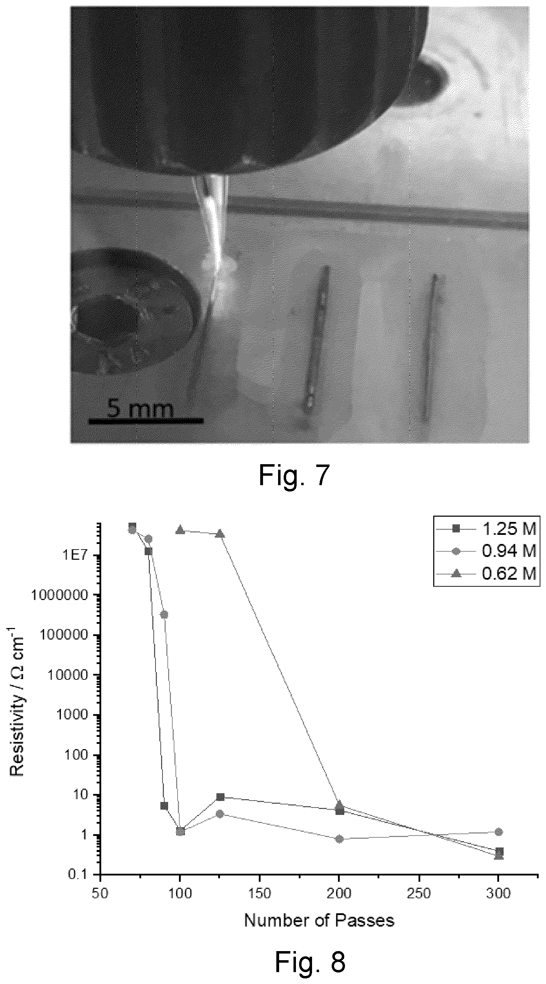

The plasma was ignited and the CuSO₄ solution was nebulized into the gas stream using the "Nebulizer A" apparatus shown in Figure 5. Figure 7 shows a photograph of conductive copper traces being plasma-deposited with the system. Printing was performed by positioning the glass slide 0.5 to 0.75 mm beneath the powered jet nozzle and translating the stage back and forth at a rate of 1 mm/s with a computer controlled two-axis translation stage (Physik Instrumente). Static deposits were also produced in this manner by keeping the translation stage at a fixed position.

### Analysis of deposits

### X-ray Photoelectron Spectroscopy (XPS)

A Thermo K-alpha photoelectron spectroscopy system equipped with a monochromatic Al-Ka (1486.6 eV) X-ray source was used for XPS spectrum acquisition. The system was operated at a spot size of 50 µm. For the deposited films, low resolution Survey spectra from 0 to 1200 eV were collected.

Depth profiling of the copper samples were done to probe further into the bulk of the material, this was done with argon ion bombardment at 1kV acceleration voltage, 500 nA ion current and 1mm raster size. A low energy electron flood gun was used during spectra collection to prevent charging, adventitious C 1s peaks for all spectra were found at 284.8 ± 0.1 eV binding energy, confirming that surface charging was minimal.

Samples for the XPS were produced with the plasma jet by depositing copper spots of roughly 1 mm diameter onto glass slides. The prepared samples were washed with deionized water prior to analysis. The samples were not cleaned via argon ion etching to remove surface contaminants unless reported otherwise.

XPS spectrum deconvolution was performed with the CasaXPS software package. The spectral peaks were first fit with a Shirley type background. If the identity of the samples were established, peaks were fit to the spectra using constraints on the line shape, FWHM and position. The parameters for the known peaks were all based on the work of Biesinger et al. (Advanced analysis of copper X-ray photoelectron spectra. Surface and Interface Analysis 2017, 49 (13), 1325-1334).

### Micro Raman Spectroscopy

A Renishaw In-Via confocal Raman microscope with an unpolarized 532 nm argon ion laser excitation source was used for characterization of copper containing films. 50x objectives were used to focus the laser beam. Samples were prepared in an identical fashion to the XPS and AES experiments of Example 2. Raman spectra were taken from an area of approximately 10 µm diameter with a 100x objective. The spectra were recorded in the 140 cm⁻¹ to 900 cm⁻¹ Raman shift range at ambient temperature.

### Stylus Profilometry

A Bruker DekTak XT stylus profilometer was used to measure the track profiles and thicknesses. The stylus radius was 5 µm and the linear scan resolution was set to 520 nm for all profilometry measurements. After data collection, the background slope due to the non-uniform glass substrate was subtracted from all results to provide a flat background.

### Scanning Electron Microscopy (SEM)

Samples for SEM imaging were produced in the form of 1 cm long traces. Samples were deposited in 5 vol% hydrogen. In order to image the time-evolution of the film morphology, different numbers of passes from 1 to 200 were made over the substrate to obtain different film thicknesses.

Scanning electron micrographs were taken with a JEOL JSM 6701F SEM at an accelerating voltage of 10 kV with samples placed perpendicularly to the electron gun. Samples were cleaned by washing in distilled water followed by acetone. The samples were sputter-coated with gold for 10 seconds prior to imaging to avoid charging artifacts in the produced images.

### Resistivity Measurements

Resistivities of the deposits were measured with a Fluke 179 digital multimeter. Samples for these measurements were identical to the samples produced for the SEM experiments. The measurements were made with a two probe configuration, measuring the trace resistance from one end to the other.

### Conductivity of deposited tracks

Measured conductivities for various films at different times and feedstock concentrations are shown in Figure 8. After 60 passes at 1 mm/s with a 1.25 M concentration of copper salt solution that is aerosolized the resistivity drops to below 10 Ω cm⁻¹. With a lower concentration of copper sulfate it takes a greater number of passes to achieve similar conductivity. Minimum resistivity was measured at 0.3 Ω cm⁻¹ (0.62 M, 300 passes). Based on the trace length of 10 mm and approximate width of 1 mm, the sheet resistance is calculated to be 30 mΩ/sq, which is 60 times higher than pure copper (0.5 mΩ/sq).

Concentration of the CuSO₄ feedstock was found have a strong effect on the time required for onset of conductivity. A sharp drop at around 80, 90 and 200 passes of the plasma jet was noted for 1.25, 0.94 and 0.62 M solutions respectively. Deposition performed with 0.31 M solutions did not become conductive during the timescale of the experiments here.

### Morphology of deposited tracks

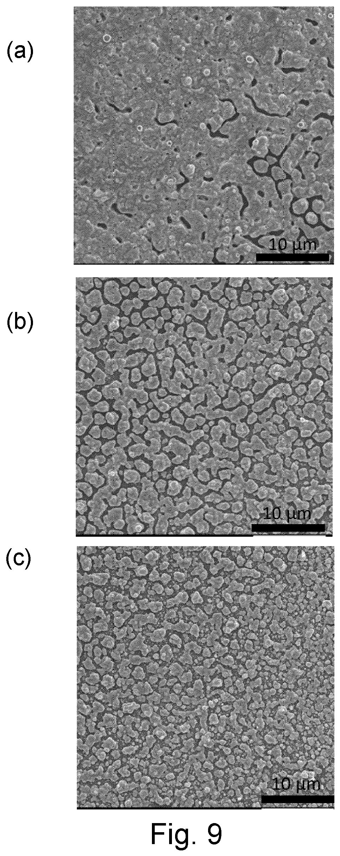

Scanning electron microscopy of the surface of the copper traces reveals the evolution of film morphology and surface coverage as deposition progresses. The micrographs shown in Figure 9 belong to copper traces deposited at 25% duty cycle and 1.25 M CuSO₄ concentration. Figures 9 (a)-(c) show the surface of the same deposited copper track moving from the centre of the track to the edge of the track.

As shown in Figure 9, near the centre of the deposit (Figure 9(a)), the copper is a contiguous layer of particles that are laid down and appear to grow. The formation of one interconnected mass in this way supports the low resistivity evidenced in Figure 8. The edges of the deposit (Figure 9(c)) show scattered individual particles 0.5 - 1 µm in diameter. Further in (Figure 9(b)), the particles are seen to be sintered together with large voids remaining in between.

The onset of conductivity of the copper films at 70 passes seems to coincide with an observed complete surface connectivity of the copper layer, as shown in Figure 9(a). The addition of further layers to the film does not change the morphology or conductivity to any significant extent after this point.

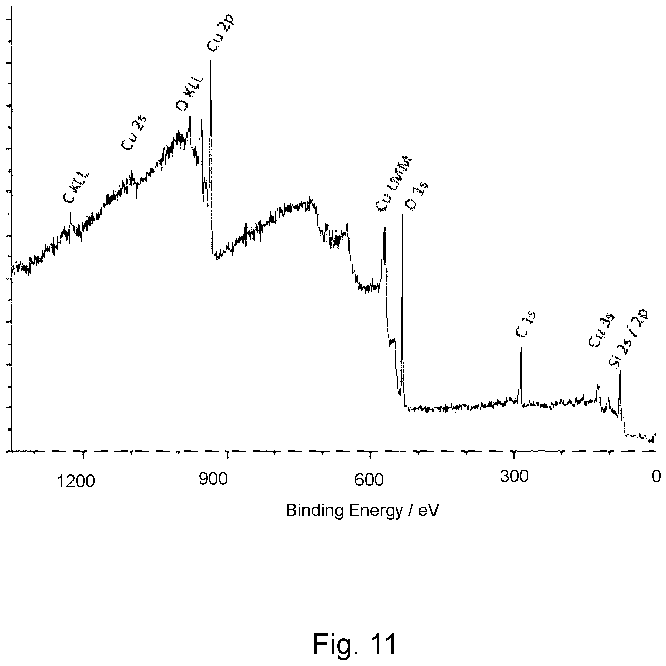

Cross-sectional areas of the tracks calculated from the profilometry experiments are shown in Figure 11. The deposits show initial rapid growth with increased number of passes which appears to slow and reverse at around 130, 100, 90 and 80 passes for the 0.31 M, 0.62 M, 0.94 M and 1.25 M solutions respectively before continuing at a slower growth rate. These points, for the given samples, approximately correspond to the onset of electrical conductivity with the exception of the 0.31 M sample. At decreasing concentrations of CuSO₄ in the aerosol solution, the average particle sizes in the deposit are found to shrink from approximately 1 µm diameter at 1.25 M to 0.10 µm at 0.31 M.

### Chemical composition of the deposit

An example XPS survey spectrum is given in Figure 11. Elements present in all samples were determined to be mostly identical, differing only in relative quantities and chemical environments. There is no incorporation of the anion or products of the anion, in this case sulfate. The low resolution survey spectra displays photoelectron signals from silicon, copper, oxygen, adventitious carbon and the corresponding Auger electron signals. The major surface contaminant was carbon, likely due to contamination from the atmosphere (dust etc.) present on all samples at a level of 9-14 at.%

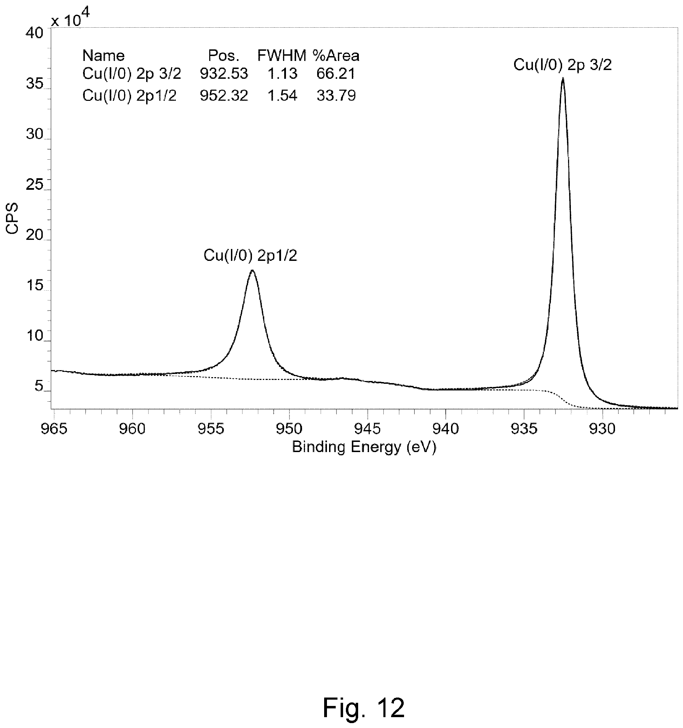

In order to quantify the change in the proportions of Cu(II) and Cu (I/0) contained in the sample, deconvolution of the high resolution Cu 2p X-ray photoelectron spectra was employed. Figure 12 shows deconvolution of XPS spectra at into 2 major components. The two components were assigned to Cu(l/0) 2p3/2 and 2p1/2 signals. Based on the conductivity of the traces and the XPS spectra obtained from the surface, the traces are composed mainly of Cu (0) species.

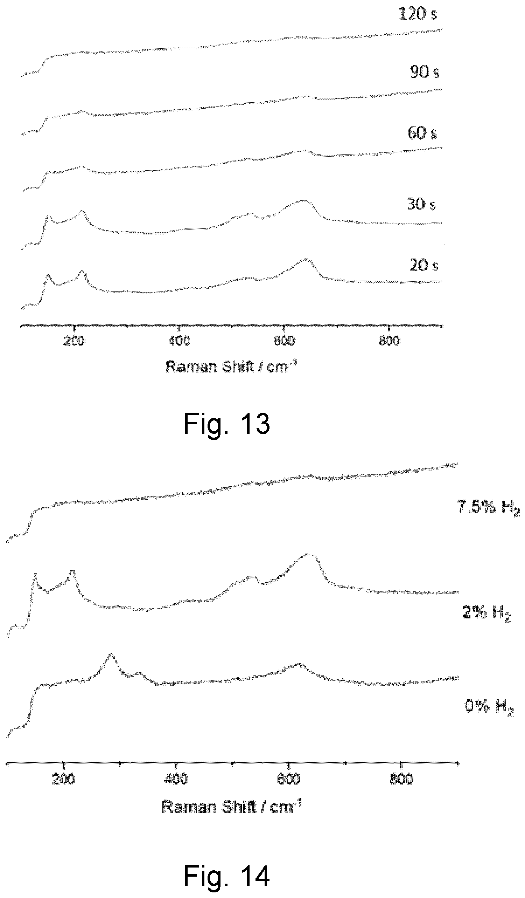

Raman spectroscopy shows the presence of little copper oxide. The copper oxide observed by XPS is from a surface layer which is formed after the deposition process and is probably only a few 10s of nanometers thick. Raman spectra collected from the samples (Figure 13) at different stages of deposition show five major bands centred around 149, 215, 413, 510 and 645 cm⁻¹, these bands can all be assigned to Cu₂O (Debbichi et al., Vibrational Properties of CuO and Cu4O3 from First-Principles Calculations, and Raman and Infrared Spectroscopy. J. Phys. Chem. C 2012, 116 (18), 10232-10237) and band positions agree with reference spectra in literature (Sander et al., Correlation of intrinsic point defects and the Raman modes of cuprous oxide. Phys. Rev. B 2014, 90 (4), 8). The peak intensities attributed to Cu₂O are seen to vanish with increased deposition time. Beyond 120 s, the sample is composed mainly of metallic copper which is Raman inactive.

When the H₂ gas was not added to the plasma gas mixture, a thin layer of porous black deposit was obtained after 100 seconds of deposition time. The Raman spectra show that the films produced without H₂ addition are composed of CuO (Figure 14). Increasing the H₂ gas concentration to 2% yields the lower oxide Cu₂O and further increasing the H₂ concentration above 5% yields metallic Cu as evidenced by XPS spectra.

Raman spectra show that initially, these deposited layers are mostly composed of Cu₂O. This provides film adherence to the glass surface, presumably because of Cu-O-Si bonds that are formed between the glass and the oxide layer, similar to the situation in the well-known metal-to-glass bonding technique "Housekeeper's seal" (Hull et al., Glass-to-metal seals. Physics-J Gen. Appl. Phys. 1934, 5 (1), 384-405).

The adhesion to the surface of the glass is excellent due to this layer.

### Example 2 - Plasma Printing of Conductive Copper Tracks on Polyimide Surfaces

An aqueous solution of copper (II) formate was made to 1.1 M concentration by dissolving solid copper (II) formate (>97 %) in water. 20 mL of this solution was poured into the ultrasonic nebulizer apparatus ("Nebulizer B") shown in Figure 6.

For the deposition process, the aerosol carrier gas was chosen as helium, the carrier was flown at a rate of 60 ml/min through the nebulizer apparatus. The aerosol laden gas was then mixed with a dry mixture of 6% v/v hydrogen in helium, flown at a rate of 150 ml/min, in a mixing manifold. This final working gas mixture, comprised of helium, hydrogen, water vapor and copper formate aerosol was flown through 2 m of tubing for thorough mixing and drying of copper formate particles.

Polyimide sheet (Kapton HN, DuPont) of 0.075 mm thickness was used as the print substrate. The flat sheet was placed on a translation stage for track printing. Printing was performed by positioning the polyimide substrate 0.2 mm beneath the powered jet nozzle and translating the stage back and forth at a rate of 0.2 mm/s, for a distance of 11 mm with a computer controlled two-axis translation stage (Physik Instrumente). Printing was initiated by starting the gas flows and setting the duty cycle of the pulse generator at 55% at 11 kHz. The peak continuous power output of the generator was set at 25W. The RF generator was then turned on, achieving ignition and creating stable plasma. The duty cycle of the pulse generator was then brought down to 30% and the substrate was translated under the plasma jet, resulting in a well sintered conductive copper track.

### Deposit Characterisation

After a single pass, the deposited copper tracks showed a resistivity of 1.2 kΩ cm⁻¹, this value was found to decrease to 2.3 Ω cm⁻¹ following a second deposition pass. Increasing the number of passes with the plasma jet did not decrease the resistivity further. This was likely due to the large contribution from probe resistivity leading to a minimum measurement of around 1 Ω. The track width was measured to be 150 µm under an optical microscope.

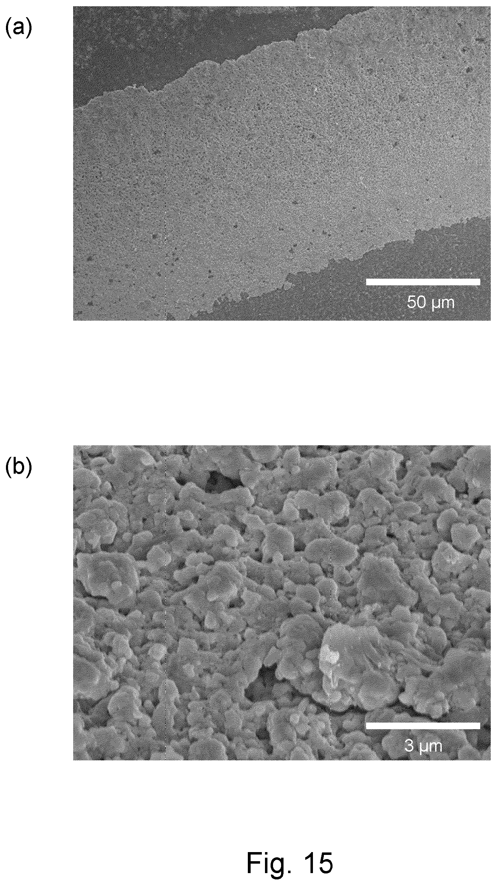

The produced tracks after two passes of the plasma jet were examined under scanning electron microscopy (SEM) for morphological characteristics, the produced micrographs are given in Figure 15(a-b). The connectivity of the tracks was found to be excellent with no discernible cracks or large voids. The surface of the deposit was composed of sintered particles with mean diameter around 1 µm. Small voids on the surface with mean diameters comparable to the particles were also visible. The sintered particle connectivity was consistent across the length and width of the track with clearly defined edges present.

Raman spectroscopy was used to characterize the chemical composition of the deposited tracks. No signal associated with copper(I/II) was present in the collected spectra suggesting minimal oxide impurity presence on the deposit surface.

### Example 3 - Plasma Printing of Conductive Silver Tracks on Poly(methylmethacrylate)

An aqueous solution of silver nitrate was made to 0.35 M concentration by dissolving solid silver nitrate in water. 20 mL of this stock solution was used to generate silver laden aerosol in the ultrasonic nebulizer apparatus ("Nebulizer B") shown in Figure 6. PMMA (acrylic) sheet (RS Pro, UK) of 2 mm thickness was used as the print substrate. Printing was initiated by starting the gas flow and setting the duty cycle of the pulse generator at 40% at 20 kHz and turning on the RF Generator. The peak continuous power output of the generator was set at 20 W. Once ignition and stable plasma was created, the duty cycle was brought down to 20% and the substrate was translated under the plasma jet, resulting in a well sintered conductive silver track.

### Deposit Characterisation

After a single pass, the deposited silver tracks showed a resistivity of 6.1 Ω cm⁻¹, this value was found to decrease to 0.7 Ω cm⁻¹ following a second deposition pass. Further deposition did not appreciably decrease the track resistivity. The track width was measured as 180 µm under an optical microscope.

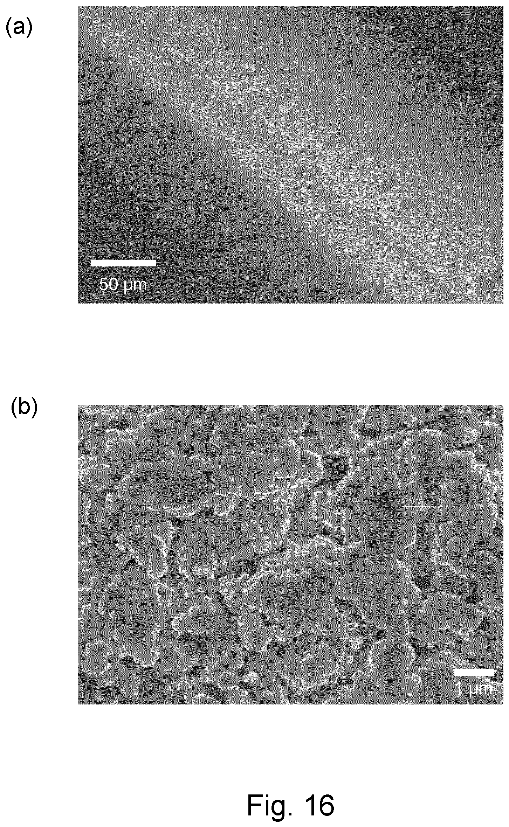

The produced tracks after two passes of the plasma jet were examined under scanning electron microscopy (SEM) for morphological characteristics, the produced micrographs are given in Figure 16(a-b). The central 50 µm of the track was found to be well sintered and devoid of large cracks or discontinuities. The peripheral sections of the tracks were found to be incompletely sintered with small cracks apparent. Under high magnification, the center of the tracks were found to be comprised of sintered silver particles around 100 nm in diameter.

### Example 4 - Plasma Printing of Conductive Gold Tracks on Soda Lime Glass

An aqueous solution of hydrogen tetrachloro aurate (>99%) was made to 0.08 M concentration by dissolving solid hydrogen tetrachloro aurate in distilled water. 20 mL of this stock solution was used to generate gold laden aerosol in the ultrasonic nebulizer apparatus ("Nebulizer B") shown in Figure 6. Glass microscope slide (VWR International, Belgium) of 1 mm thickness was used as the print substrate. Printing was initiated by starting the gas flow and setting the duty cycle of the pulse generator at 40% at 20 kHz and turning on the RF generator. The peak continuous power output of the generator was set at 20W. Once ignition and stable plasma was created, the duty cycle was brought down to 20% and the substrate was translated under the plasma jet, resulting in a well sintered conductive gold track.

### Deposit Characterisation

After a single pass, the deposited silver tracks showed a resistivity of 0.8 Ω cm⁻¹, this value did not decrease with repeated passes. The track width was measured to be 250 µm under an optical microscope.

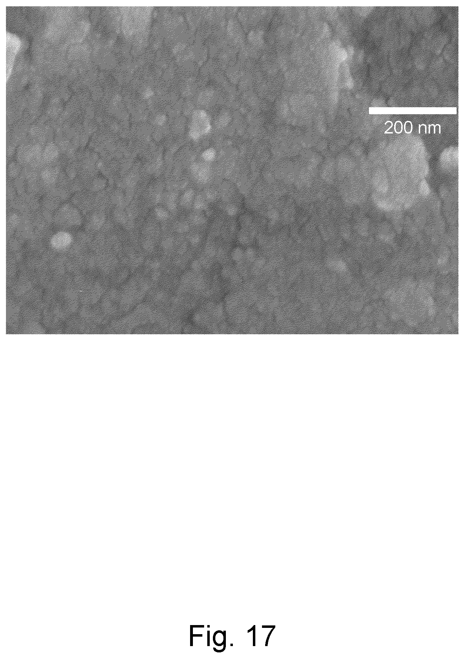

SEM was used to characterise the track surface, the produced high magnification micrograph is given in Figure 17. The surface appeared exceptionally uniform and well sintered under low magnification, no voids or cracks were present. Under higher magnification, the surface was seen to be made up of deposited gold particles with an average diameter of 20 nm.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the words "have", "comprise", and "include", and variations such as "having", "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means, for example, +/- 10%.

The words "preferred" and "preferably" are used herein refer to embodiments of the invention that may provide certain benefits under some circumstances. It is to be appreciated, however, that other embodiments may also be preferred under the same or different circumstances. The recitation of one or more preferred embodiments therefore does not mean or imply that other embodiments are not useful, and is not intended to exclude other embodiments from the scope of the disclosure, or from the scope of the claims.

The following numbered paragraphs (paras.) contain further statements of various aspects of the present invention:
Para 1. A process for preparing a deposit on a substrate using atmospheric pressure plasma jet deposition, comprising:
   feeding a solution comprising a dissolved metal precursor into a plasma jet, wherein the dissolved metal precursor comprises a precursor metal selected from Groups 2 to 16, with the proviso that the precursor metal does not comprise Mn; and
   directing the plasma jet towards a surface of the substrate such that material from the plasma jet becomes deposited onto the surface of the substrate.
Para 2. A process according to para 1, wherein the concentration of the precursor metal in the solution is at least 0.001 M.
Para 3. A process according to para 2, wherein the concentration of the precursor metal in the solution is at least 0.2 M, preferably at least 0.3 M.
Para 4. A process according to any one of paras 1 to 3, wherein the precursor metal is a metal selected from Groups 2 to 6 or Groups 8 to 16.
Para 5. A process according to any one of paras 1 to 4, wherein the plasma is a non-thermal plasma.
Para 6. A process according to any one of paras 1 to 5, wherein the solution is an aqueous solution.
Para 7. A process according to any one of paras 1 to 6, wherein the solution contains less than 0.5 wt% solid material.
Para 8. A process according to any one of paras 1 to 7, wherein the solution is at least 25% saturated.
Para 9. A process according to any one of paras 1 to 8, wherein the dissolved metal precursor contains a single species of precursor metal.
Para 10. A process according to any one of paras 1 to 9, wherein the dissolved metal precursor comprises a metal salt, a metal complex or a mixture thereof.
Para 11. A process according to para 10, wherein the dissolved metal precursor comprises a transition metal salt, transition metal complex or mixture thereof.
Para 12. A process according to para 11, wherein the transition metal salt or complex comprises one or more metals selected from copper (Cu), ruthenium (Ru), rhodium (Rh), palladium (Pd), silver (Ag), rhenium (Re), osmium (Os), iridium (Ir), platinum (Pt), chromium (Cr), gold (Au) and mercury (Hg).
Para 13. A process according to para 11, wherein the transition metal salt or complex comprises one or more metals selected from Cu, Au and Ag.
Para 14. A process according to any one of paras 1 to 13, wherein the deposit on the substrate is a metallic deposit.
Para 15. A process according to any one of paras 1 to 14, wherein the deposit comprises a conductive, semiconducting or insulating track.
Para 16. A process according to any one of paras 1 to 15, wherein the deposit on the substrate provides one or more properties selected from antibacterial properties, magnetic properties, optical properties, sensor properties, catalytic properties and anti-corrosion properties.
Para 17. A process according to any one of paras 1 to 16, wherein the substrate is a planar substrate or wherein the substrate is a three-dimensional substrate.
Para 18. A process according to any one of paras 1 to 17, wherein the surface of the substrate comprises a material selected from plastic, metal, ceramic, biological material and glass.
Para 19. A process according to any one of paras 1 to 18, wherein the solution is nebulised to produce an aerosol which is fed into the plasma jet.
Para 20. A process according to para 19, further comprising providing a feed gas and mixing the feed gas with the aerosol to provide a mixture before feeding the mixture into the plasma jet.
Para 21. A process according to para 20, wherein the feed gas comprises an inert gas.
Para 22. A process according to para 21, wherein the feed gas further comprises a reducing gas.
Para 23. A process according to para 22, wherein the reducing gas is selected from hydrogen and methane.
Para 24. A process according to any one of paras 21 to 23, wherein the inert gas is selected from one or more of He and Ar.
Para 25. A process according to any one of paras 1 to 24, wherein the plasma jet is ignited and stabilised by an electrode connected to a radio frequency generator.
Para 26. A process according to any one of paras 1 to 25, wherein the plasma jet is pulsed, optionally providing a duty cycle of 10 to 40%.
Para 27. A process according to any one of paras 1 to 26, comprising depositing a first layer of a first material onto the surface of the substrate, followed by depositing a second layer of a second material onto the first layer, wherein the first and second materials are different.
Para 28. A process according to para 27, wherein the first material is a material which exhibits greater adhesion to the surface of the substrate than the second material.
Para 29. A process according to para 27 or 28, wherein the first material is selected from Ag and Au.
Para 30. A process according to any one of paras 1 to 29, further comprising sintering at least a portion of the deposit after deposition onto the substrate, wherein the sintering is performed by exposing the deposit to the plasma jet.
Para 31. Apparatus for atmospheric pressure plasma jet deposition of a deposit on a substrate, the apparatus comprising:
   a feed solution comprising a dissolved metal precursor, wherein the dissolved metal precursor comprises a metal selected from Groups 2 to 16, with the proviso that the dissolved metal precursor does not comprise Mn;
   a plasma jet generator which generates a plasma jet directable towards the substrate; and
   means to direct the feed solution into the plasma jet.
Para 32. A deposit on the surface of a substrate obtained or obtainable by a process according to any one of paras 1 to 30.
Para 33. A substrate comprising a deposit on a surface thereof, wherein the deposit is obtained or obtainable by a process according to any one of paras 1 to 30.

## Claims

1. A process for preparing a deposit on a substrate using atmospheric pressure plasma jet deposition, comprising:
feeding a solution comprising a dissolved metal precursor into a plasma jet, wherein the dissolved metal precursor comprises a precursor metal selected from Groups 2 to 16, with the proviso that the precursor metal does not comprise Mn; wherein the solution is fed to the plasma jet as an aerosol, the process comprising providing a feed gas and mixing the feed gas with the aerosol to provide an aerosol/gas mixture before feeding the mixture into the plasma jet, wherein the feed gas comprises an oxidizing gas or an oxidizing gas mixture; and
directing the plasma jet towards a surface of the substrate such that material from the plasma jet becomes deposited onto the surface of the substrate;
and wherein the dissolved metal precursor is a precursor to the deposit formation made up of solvated atoms, molecules or ions in solution.

2. The process according to claim 1, wherein the overall flow rate of gas through a plasma nozzle is 20 mL/min to 600 mL/min.

3. The process according to claim 1 or 2, wherein the aerosol/gas mixture is dried to reduce the droplet size of the aerosol before feeding into the plasma jet.

4. The process according to any one of claims 1 to 3, wherein the aerosol/gas mixture is supplied to a plasma nozzle before ignition to form plasma.

5. The process according to any one of claims 1 to 4, wherein the concentration of the precursor metal in the solution is at least 0.001 M, preferably at least 0.2 M, and more preferably at least 0.3 M.

6. The process according to any one of claims 1 to 5, wherein the precursor metal is a metal selected from Groups 2 to 6 or Groups 8 to 16.

7. The process according to any one of claims 1 to 6, wherein the dissolved metal precursor contains a single species of precursor metal.

8. The process according to any one of claims 1 to 7, wherein the dissolved metal precursor comprises a metal salt, a metal complex or a mixture thereof; optionally wherein the dissolved metal precursor comprises a transition metal salt, transition metal complex or mixture thereof.

9. The process according to claim 8, wherein the transition metal salt or complex comprises one or more metals selected from copper (Cu), ruthenium (Ru), rhodium (Rh), palladium (Pd), silver (Ag), rhenium (Re), osmium (Os), iridium (Ir), platinum (Pt), chromium (Cr), gold (Au) and mercury (Hg).

10. The process according to any one of claims 1 to 9, wherein the surface of the substrate comprises a material selected from plastic, metal, ceramic, biological material and glass.

11. The process according to any one of claims 1 to 10, wherein the feed gas comprises an inert gas.

12. The process according to any one of claims 1 to 11, wherein the plasma jet is ignited and stabilised by an electrode connected to a radio frequency generator.

13. The process according to any one of claims 1 to 12, wherein the plasma jet is pulsed, optionally providing a duty cycle of 10 to 40%.

14. The process according to any one of claims 1 to 13, further comprising sintering at least a portion of the deposit after deposition onto the substrate, wherein the sintering is performed by exposing the deposit to the plasma jet.
